# EUROPEAN PATENT APPLICATION

(11) **EP 2 246 911 A2**
(43) Date of publication of application: **03.11.2010**
(21) Application number: 09770361.5
(22) Date of filing: 23.06.2009
(51) Int. Cl.: H01L 33/00

(54) **LIGHT EMITTING DEVICE PACKAGE**

(30) Priority: 24.06.2008 KR 20080059517
(71) Applicant: LG Innotek Co., Ltd., Seoul 100-714 (KR)
(72) Inventor: AN, Joong In, Seoul, 100-714 (KR)
(74) Representative: Cabinet Plasseraud
(86) International application number: PCT/KR2009/003363
(87) International publication number: WO 2009/157689

(57) **Abstract**

Provided is a light emitting device package. The light emitting device package comprises a package body, a light emitting device, and a transient voltage suppress diode. The package body comprises a plurality of electrodes. The light emitting device is electrically connected to the plurality of electrodes. The transient voltage suppress diode is electrically connected to the plurality of electrodes.

## Description

### BACKGROUND

The present disclosure relates to a light emitting device package.

Due to their physical and chemical characteristic, Group III-V nitride semiconductors are being esteemed as core materials for light emitting devices such as Light Emitting Diodes (LEDs) and Laser Diodes (LDs). Group III-V nitride semiconductors are typically formed of semiconductor materials having a composition formula of InₓAl_{y}Ga_{1-x-y}N (where 0≤ x≤ 1, 0≤ y≤ 1, and 0≤ x+y≤ 1) .

LEDs are a kind of semiconductor device that can exchange signals or be used as a light source by converting electricity into infrared rays or light using the characteristics of compound semiconductors.

Nitride semiconductor-based LEDs or LDs are being widely used in light emitting devices, and being applied as light sources for various products such as keypad lighting units for mobile phones, electronic display boards, and lighting devices.

### SUMMARY

Embodiments provide a light emitting device package comprising a transient voltage suppress diode.

Embodiments provide a light emitting device package comprising a transient voltage suppress diode in a package body.

Embodiments provide a light emitting device package comprising a transient voltage suppress diode and a light emitting device connected to a plurality of electrodes in parallel.

Embodiments provide a light emitting device package comprising a transient voltage suppress diode flip-bonded to a plurality of electrodes in a package body.

An embodiment provides a light emitting device package comprising: a package body comprising a plurality of electrodes; a light emitting device electrically connected to the plurality of electrodes; and a Transient Voltage Suppress (TVS) diode electrically connected to the plurality of electrodes.

An embodiment provides a light emitting device package comprising: a package body having a cavity; a plurality of electrodes disposed in the cavity; a light emitting device electrically connected to the plurality of electrode; and a transient voltage suppress diode electrically connected to the plurality of electrodes in the package body.

The details of one or more embodiments are set forth in the accompanying drawings and the description below. Other features will be apparent from the description and drawings, and from the claims.

### BRIEF DESCRIPTION OF THE DRAWINGS

Fig. 1 is a side cross-sectional view illustrating a light emitting device package according to a first embodiment.

Fig. 2 is another cross-sectional view taken in a different direction from that of FIG. 1.

Fig. 3 is a circuit view illustrating a light emitting device and a transient voltage suppress diode of FIG. 1.

Fig. 4 is a graph illustrating operation characteristics of a transient voltage suppress diode of FIG. 1.

Fig. 5 is a circuit view illustrating another exemplary transient voltage suppress diode as shown in FIG. 1.

Fig. 6 is a side cross-sectional view illustrating a light emitting device package according to a second embodiment.

Fig. 7 is a side cross-sectional view illustrating a light emitting device package according to a third embodiment.

Fig. 8 is a side cross-sectional view illustrating a light emitting device package according to a fourth embodiment

Fig. 9 is a side cross-section view illustrating a surface light source device using the light emitting device package of FIG. 1.

### DETAILED DESCRIPTION OF THE EMBODIMENTS

Reference will now be made in detail to the embodiments of the present disclosure, examples of which are illustrated in the accompanying drawings.

A light emitting device package according to an embodiment will be described in detail with reference to the accompanying drawings. The invention may, however, be embodied in many different forms and should not be construed as being limited to the embodiments set forth herein; rather, that alternate embodiments included in other retrogressive inventions or falling within the spirit and scope of the present disclosure can easily be derived through adding, altering, and changing, and will fully convey the concept of the invention to those skilled in the art.

Hereinafter, exemplary embodiments will be described in detain with reference to the accompanying drawings.

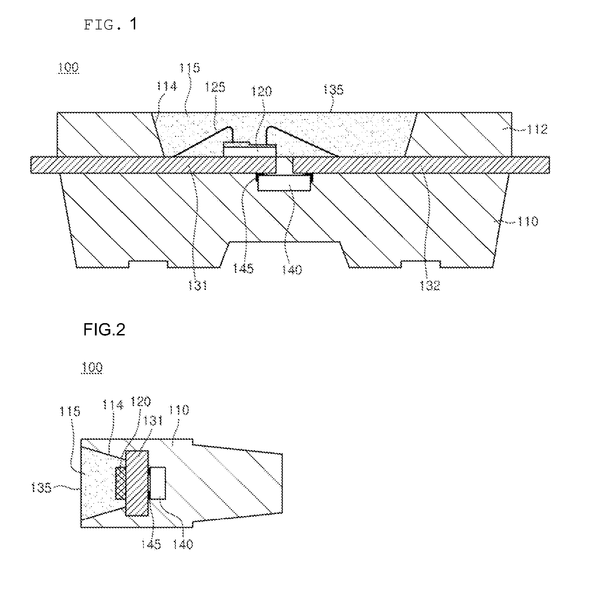

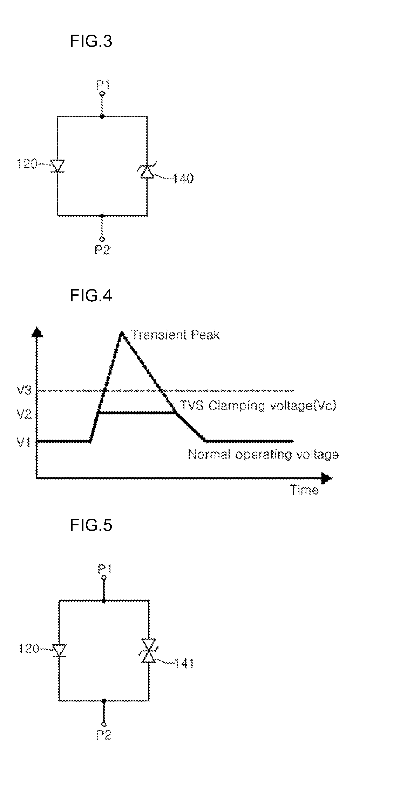

Fig. 1 is a side cross-sectional view illustrating a light emitting device package according to a first embodiment. Fig. 2 is another cross-sectional view taken in a different direction from that of FIG. 1. Fig. 3 is a circuit view illustrating a light emitting device and a transient voltage suppress diode of FIG. 1. Fig. 4 is a graph illustrating operation voltages of a transient voltage suppress diode of FIG. 1.

Referring to Figs. 1 and 2, a light emitting device package 100 may include a package body 110 having a cavity 115, a plurality of electrodes 131 and 132, a light emitting device 120, and a Transient Voltage Suppress (TVS) diode 140.

The light emitting device package 100 may be implemented in a side-view type or a top-view type, and be used as light sources for light units, electronic display boards, and lighting devices. Hereinafter, the side-view type light emitting device package will be described for convenience of explanation.

The package body 110 may be injection-molded from polyphthalamid (PPA), liquid crystal polymer (LCP), and syndiotactic polystyrene (SPS)

The cavity 115 may be formed to have a certain depth in the upper part 112 of the package body 110. The cavity 115 may have a cup, concave, or bathtub shape, but is not limited thereto. The external shape of the cavity 115 may be formed to be circular or polygonal.

The sidewall 114 of the cavity 115 may be vertical or inclined to the bottom surface of the cavity 115, and may be coated with a reflecting material for optical reflection.

Here, the package body 110 and the upper part 112 thereof may be integrally injection-molded, or may be separately formed and combined. In an embodiment, the cavity 115 may not be provided in the package body 110.

The plurality of electrodes 131 and 132 may be horizontally disposed through the package body 110. The electrodes 131 and 132 may be formed of lead frames including metals such as Al, Ag, Au, Cu, Pd, Ir, and Rh.

One ends of the plurality of electrode 131 and 132 may be disposed in the cavity 115 to be spaced from each other. In this case, at least one of the plurality of electrodes 131 and 132 may have a via hole structure, but embodiments are not limited thereto.

The other ends of the plurality of electrodes 131 and 132 may be extended to the side surface or the rear surface of the package body 110, and may be used as external electrodes.

The electrodes 131 and 132 may be injection-molded together with the package body 110. The transient voltage suppress diode 140 may be mounted onto the plurality of electrodes 131 and 132 prior to the injection molding of the package body 110. The transient voltage suppress diode 140 may be disposed under the plurality of electrodes 131 and 132. The transient voltage suppress diode 140 may be bonded to the plurality of electrodes 131 and 132 by a flip-chip bonding.

The transient voltage suppress diode 140 and the electrodes 131 and 132 may be connected to each other by a connection member 145 selectively including conductive adhesives, solder balls, Ag pastes, and the like.

The transient voltage suppress diode 140 may be mounted under the plurality of electrodes 131 and 132 without wires prior to the injection molding of the package body 110. Here, the transient voltage suppress diode 140 may be sized not to affect the package body 110, and may be disposed in the package body 110.

A process for injection-molding the package body 110 may include mounting the transient voltage suppress diode 140 onto the plurality of electrodes 131 and 132 and then injecting a liquid material into a mold. In this case, even when the liquid material is injected into the mold, the transient voltage suppress diode 140 may not be electrically damaged. That is, since the transient voltage suppress diode 140 does not use a wire, an electrical limitation due to the use of wire can be overcome in the injection molding of the package body 110.

The light emitting device 120 may be disposed in the cavity 115 together with the plurality of electrodes 131 and 132. The light emitting device 120 may be attached on the first electrode of the plurality of electrodes 131 and 132, and may be electrically connected to the first and second electrodes 131 and 132 through wires.

The light emitting device 120 may be formed of one of color LED chips such as a blue LED chip, a green LED chip, a red LED chip, and a yellow green LED chip and a UV LED chip, or a combination thereof. The light emitting device 120 may be bonded by a wire-bonding or a flip-chip bonding based on the type of chips, but is not limited thereto.

A resin material 135 may be disposed in the cavity 115. The resin material 135 may be molded from a transparent resin such as silicon or epoxy, and may include at least one type of phosphors. If the light emitting device 120 is a blue LED chip, the phosphor may be a yellow phosphor. In the light emitting device 120 is a UV LED chip, the phosphor may be a red, blue, or green phosphor. The combination of the light emitting device and the phosphor may be varied with target light.

The transient voltage suppress diode 140 may be connected in anti-parallel to the light emitting device 120. For example, a first electrode pad (not shown) of the light emitting device 120 and a second electrode pad (not shown) of the transient voltage suppress diode 140 may be connected to the first electrode, and a second electrode pad (not shown) of the light emitting device 120 and a first electrode pad (not shown) of the transient voltage suppress diode 140 may be connected to the second electrode 132.

The transient voltage suppress diode 140 may be a unidirectional avalanche diode or Zener diode, which is a component for protecting the circuit of the light emitting device 120 from electrical shocks. The transient voltage suppress diode 140 may be used for absorbing a transient voltage inputted to the light emitting device 120. For example, the transient voltage suppress diode 140 may protect the light emitting device 120 from a surge of high current/high voltage induced by the falling of a thunderbolt or a surge induced by adjacent high-voltages lines.

If a voltage that may damage the light emitting device 120 flows, the transient voltage suppress diode 140 restricts the size of the voltage by a clamping voltage or an avalanche operation of PN-junction reducing the voltage to a level that does not damage the light emitting device 120. Also, if a transient phenomenon occurs, the transient voltage suppress diode 140 may restrict to a safety voltage, which is a clamping voltage, and simultaneously conduct a potential circuit-damaging current.

The package body 110 may be implemented using a silicon wafer, which may be an N-type or P-type substrate. The transient voltage suppress diode 140 may be integrated by diffusing impurities into the silicon wafer. For example, when the silicon water is an N-type substrate, a P-type impurity is diffused to implement the transient voltage suppress diode 140 of a PN-junction, which may be electrically connected to a plurality of electrodes (e.g., plating layer) and light emitting device 120. Also, a storage space may be formed in the silicon wafer, and the transient voltage suppress diode 140 may be mounted onto the plurality of electrodes. This modified example may be implemented within the technical scope of the inventive concept.

Referring to Figs. 3 and 4, the transient voltage suppress diode 140 may be connected in anti-parallel to the light emitting device 120. The transient voltage suppress diode 140 suppresses an electrostatic discharge (ESD) or a transient voltage to protect the light emitting device 120.

The transient voltage suppress diode 140 may be connected in parallel to the light emitting device 120 in the package body 110, and bypass an input current when a threshold voltage V3 is exceeded at the both ends of the light emitting device 120, and restrict a voltage applied at the both ends of the light emitting device 120 to a low clamping voltage Vc, thereby protecting the light emitting device 120.

Here, the transient voltage suppress diode 140 has fast response characteristics with respect to rising time of an ESD pulse of no more than about Ins, thereby processing a higher current in a shore duration. Also, the transient voltage suppress diode 140 may suppress a transient current to an enough low level not to damage the light emitting device 120.

Fig. 5 is a circuit view illustrating another exemplary transient voltage suppress diode as shown in FIG. 1.

Referring to Fig. 5, a transient voltage suppress diode 141 may be connected in parallel to a light emitting device 120, and may be configured with a bidirectional avalanche diode. The threshold voltage and clamping voltage characteristics of the transient voltage suppress diode 141 are determined by a reverse stand-off voltage. The transient voltage suppress diode 141 may protect the light emitting device 120 from a transient voltage or current flowing to both electrodes of the light emitting device 120.

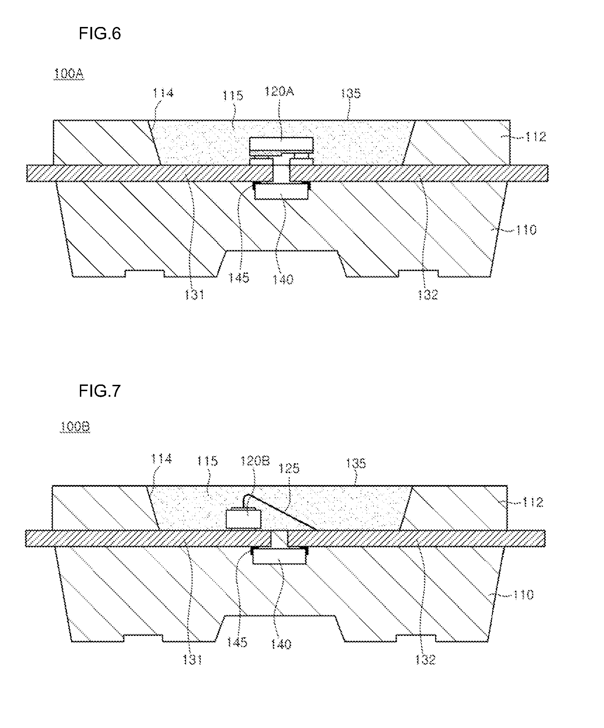

Fig. 6 is a side cross-sectional view illustrating a light emitting device package according to a second embodiment. For explanation of the second embodiment, detailed description of the parts identical to those of the first embodiment will be omitted herein by referring to the first embodiment.

Referring to Fig. 6, a light emitting device package 100A may include a plurality of electrodes 131 and 132 disposed on a package body 110 thereof. A light emitting device 120A may be disposed on the plurality of electrodes 131 and 132 through a flip-chip bonding process. The light emitting device 120A may be configured with a lateral type LED chip, and may be electrically connected to the plurality of electrodes 131 and 132 using Au bumps.

A transient voltage suppress diode 140 may be disposed under the plurality of electrodes 131 and 132 in the package body 110 through a flip-chip bonding process. Thus, the light emitting device 120A may correspond to the transient voltage suppress diode 140, forming a parallel circuit.

Fig. 7 is a side cross-sectional view illustrating a light emitting device package according to a third embodiment. For explanation of the third embodiment, detailed description of the parts identical to those of the first embodiment will be omitted herein by referring to the first embodiment.

Referring to Fig. 7, a light emitting device package 100B may include a plurality of electrodes 131 and 132 disposed on a package body 110 thereof. A light emitting device 120B may be die-bonded to the first electrode 131 with a conductive adhesive, and may be connected to the second electrode 132 through a wire. The light emitting device 120B may be configured with a vertical type LED chip.

A transient voltage suppress diode 140 may be disposed under the plurality of electrodes 131 and 132 in the package body 110 through a flip-chip bonding process. Thus, the light emitting device 120B may correspond to the transient voltage suppress diode 140, forming a parallel circuit.

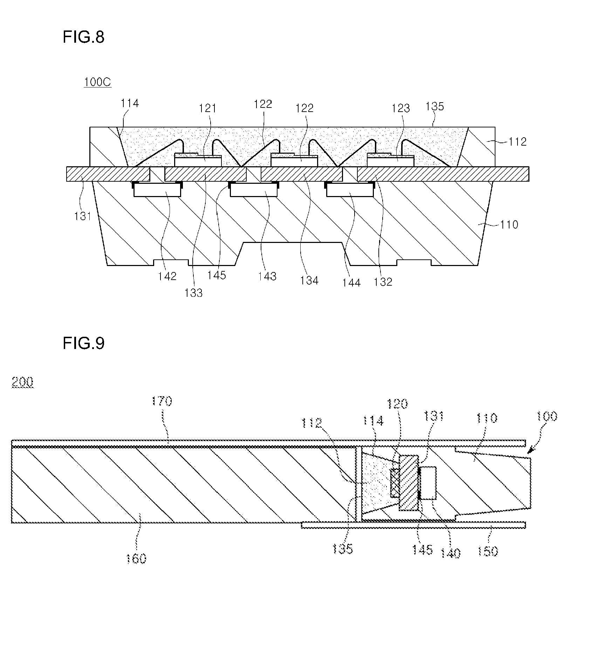

Fig. 8 is a side cross-sectional view illustrating a light emitting device package according to a fourth embodiment. For explanation of the fourth embodiment, detailed description of the parts identical to those of the first embodiment will be omitted herein by referring to the first embodiment.

Referring to Fig. 8, a light emitting device package 100C may include a plurality of light emitting devices 121, 122 and 123 and a plurality of transient voltage suppress diodes 142, 143 and 144.

The plurality of electrodes 131, 132, 133 and 134 may disposed in a cavity 115 of a package body 110. The plurality of light emitting devices 121, 122 and 123 may be connected in series to the plurality of electrodes 131, 132, 133 and 134. The light emitting devices 121, 122 and 123 may be disposed by at least one of a wire bonding or a flip-chip bonding according to the types of chips, but embodiments are not limited thereto.

The configuration of the plurality of electrodes 131, 132, 133 and 134 may be varied with the number of the light emitting devices 121, 122 and 123. For example, serial connection of the three light emitting devices 121, 122 and 123 may be achieved by the four electrodes 131, 132, 133 and 134. One ends of the first and second electrodes 131 and 132 may be extended to the outside of the package body 110. Here, the plurality of light emitting devices 121, 122 and 123 may be connected in parallel to each other, and thus the electrode pattern may be varied. The plurality of electrodes 131, 132, 133 and 134 may be straightly disposed at a certain interval in the cavity 115.

Transient voltage suppress diodes 142, 143 and 144 may be disposed under the plurality of electrodes 131, 132, 133 and 134 by a flip-chip bonding process, forming a parallel circuit together with the respective light emitting devices 121, 122 and 123. For example, the first light emitting device 121 and the first transient voltage suppress diode 142 may be connected in parallel to the electrodes 131 and 133. The second light emitting device 122 and the second transient voltage suppress diode 143 may be connected in parallel to the electrodes 133 and 134. The third light emitting device 123 and the third transient voltage suppress diode 144 may be connected in parallel to the electrodes 134 and 132.

The plurality of transient voltage suppress diodes 142, 143 and 144 may be embedded in the package body 110.

Here, when the plurality of light emitting devices 121, 122 and 123 are disposed in parallel, a singly transient voltage suppress diode may be used.

Fig. 9 is a side cross-section view illustrating a surface light source device using the light emitting device package of FIG. 1

Referring to Fig. 9, a surface light source device 200 may include a light emitting device package 100, a light guide plate 160, a reflection plate 170, and a printed circuit board 150. At least one light emitting device package 100 may be arranged on the printed circuit board 150. The light guide plate 160 may be disposed on a light emitting surface of the light emitting device package 100. The light guide plate 160 may be formed of poly(methyl methacrylate)(PMMA), polycarbonate (PC), and the like. The light guide plate 160 may irradiate a surface light source using a point light source emitted from the light emitting device package 100.

A reflection pattern (not shown) may be disposed on the upper and/or lower surface of the light guide plate 160. The reflection pattern may effectively reflect light travelling in the light guide plate 160.

The reflection plate 170 may be disposed at the opposite side of the emitting surface of the light guide plate 160, thereby reflecting a leakage light from the light guide plate 160.

The surface light source emitted from the light guide plate 160 may be diffused and condensed using at least one optical sheet such as a diffusion sheet and a prism sheet. A surface light emitting device according to an embodiment can be used as light sources for lighting devices and a front light and/or a back light of liquid crystal display devices of mobile phones, computers, and the like.

Embodiments provide a light emitting device package as light sources for display and lighting.

Embodiments also provide a light emitting device package having a transient voltage protecting device.

Embodiments can improve reliability of a light emitting device package by using a transient voltage suppress diode to protect a light emitting device.

Embodiments can also protect a light emitting device from a transient voltage.

Embodiments can also improve electrical reliability of a light emitting device package by flip-bonding a transient voltage suppress diode to a plurality of electrodes in a package body.

Embodiments can also protect a light emitting device from a transient voltage or an electrical shock (e.g., electrostatic discharge (ESD)) by connecting a transient voltage suppress diode in parallel to the light emitting device.

Embodiments can also protect a light emitting device from a transient current for a short duration by connecting a transient voltage suppress diode having quick response characteristics in parallel to the light emitting device.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A light emitting device package comprising:
a package body comprising a plurality of electrodes;
a light emitting device electrically connected to the plurality of electrodes; and
a Transient Voltage Suppress (TVS) diode electrically connected to the plurality of electrodes.

2. The light emitting device package according to claim 1, wherein the plurality of electrodes comprise lead frames formed on the package body.

3. The light emitting device package according to claim 1, wherein the transient voltage suppress diode is disposed in the package body.

4. The light emitting device package according to claim 3, wherein the transient voltage suppress diode is flip-bonded under the plurality of electrodes.

5. The light emitting device package according to claim 1, wherein the light emitting device and the transient voltage suppress diode are connected in anti-parallel to each other.

6. The light emitting device package according to claim 4, wherein the transient voltage suppress diode is mounted onto the plurality of electrodes by one of solder ball, Ag paste, and conductive adhesive.

7. The light emitting device package according to claim 1, wherein the package body comprises one of polyphthalamid (PPA), liquid crystal polymer (LCP), and syndiotactic polystyrene (SPS).

8. The light emitting device package according to claim 1, wherein the transient voltages suppress diode comprises a unidirectional avalanche diode or a bidirectional avalanche diode.

9. The light emitting device package according to claim 1, wherein the light emitting device comprises at least one of color LED chips or UV LED chips.

10. The light emitting device package according to claim 1, wherein the light emitting device comprises a plurality of LED chips, and the plurality of LED chips are connected to each other in series or in parallel.

11. The light emitting device package according to claim 10, wherein the plurality of transient voltage suppress diode are connected in parallel to the respective LED chips that are connected in series to each other.

12. A light emitting device package comprising:
a package body having a cavity;
a plurality of electrodes disposed in the cavity;
a light emitting device electrically connected to the plurality of electrode; and
a transient voltage suppress diode electrically connected to the plurality of electrodes in the package body.

13. The light emitting device package according to claim 12, wherein the transient voltage suppress diode is flip-bonded under the plurality of electrodes.

14. The light emitting device package according to claim 12, comprising a light-transmitting resin or a phosphor-added resin formed in the cavity.

15. The light emitting device package according to claim 12, wherein the light emitting device comprises at least one LED chip, and is bonded to the plurality of electrodes by at least one of a wire-bonding or a flip-bonding.
